# EUROPEAN PATENT SPECIFICATION

(11) **EP 3 161 897 B1**
(45) Date of publication and mention of the grant of the patent: **11.03.2020**
(21) Application number: 15815261.1
(22) Date of filing: 12.06.2015
(51) Int. Cl.: H01M 10/48, H01M 10/42, G01R 31/36, H01M 10/653, H01M 2/20, H01M 2/10

(54) **BATTERY MODULE AND SIGNAL COLLECTION UNIT OF THE SAME**
BATTERIEMODUL UND SIGNALERFASSUNGSEINHEIT DAVON
MODULE DE BATTERIE ET SON UNITÉ DE COLLECTE DE SIGNAUX

(30) Priority: 30.06.2014 CN 201420355953 U; 30.06.2014 CN 201420354602 U
(43) Date of publication of application: 03.05.2017
(73) Proprietor: BYD Company Limited, Shenzhen, Guangdong 518118 (CN)
(72) Inventor: ZHAO, Jiyang, Shenzhen Guangdong 518118 (CN); LAI, Qing, Shenzhen Guangdong 518118 (CN); ZHU, Yan, Shenzhen Guangdong 518118 (CN); ZHU, Jianhua, Shenzhen Guangdong 518118 (CN)
(74) Representative: m patent group
(86) International application number: PCT/CN2015/081381
(87) International publication number: WO 2016/000521

(56) References cited:
- WO-A1-2012/075948
- WO-A1-2012/075948
- WO-A1-2013/089114
- CN-A- 102 956 934
- CN-U- 203 103 361
- CN-U- 204 029 949
- CN-U- 204 029 950
- US-A1- 2009 154 048
- US-A1- 2010 098 974

## Description

### FIELD

The present invention generally relates to a power battery field, and especially relates to a battery module and a signal collection unit of the same.

### BACKGROUND

It is well known that an energy storage battery system consists of tens of, hundreds of or even thousands of batteries connected in series or parallel, in order to manage the energy storage battery system well, it is needed to collect a state signal, such as a voltage signal and a temperature signal of the battery, which may provide a basis for safety monitoring and service life optimizing of the energy storage battery system.

In the related art, an integrated component of power connection and signal collection usually includes a power connection element and a signal collection element disposed on one side of the power connection element. The power connection element includes a bracket, a protection cover and a plurality of connection sheets disposed within the bracket and the protection cover. The signal collection element includes a line groove, a protection cap, and a signal collection line received in the line groove and the protection cap. The signal collection line is electrically connected to the connection sheet in the power connection element via a signal collection terminal. When the integrated component is to be used, the protection cover should first be removed, then the battery is installed on a bottom of the bracket, and a leading column of the battery is penetrated through a baffle plate of the bracket and fixed to the connection sheet via a first positioning hole, and then the protection cover is closed. The power connection is implemented by a connection of the other end of the battery, and then a subsequent signal collection can be performed.

However, this kind of integrated component of the power connection and signal collection has following disadvantages:
1. Its structure is relatively incompact, it is installed mainly via manual work, and thus it has a low production efficiency and a poor install stability.
2. It has a large size. When the integrated component is designed, a structure space should be specially developed to arrange and fasten a cable and a pipe. Therefore, an invalid mode, such as breakage or friction damage, may be introduced between a functional element of the integrated component and a conducting wire or other connection elements due to offset and drag thereof.
3. It may have a high cost. Since its structure is relatively complicated, its manufacturing process is original, and an automation level thereof is low, therefore, this kind of integrated component may have a high cost.
4. It may have a long development cycle. The integrated component has various kinds of elements and an arrangement structure thereof is limited apparently, thus resulting in a long development cycle.
5. It may be difficult to maintain the integrated component. Since the integrated component has a complex structure and various elements, once the integrated components breaks down, it is difficult to find out where the problem is and how to maintain the integrated component.

WO 2013/089114 A1 discloses a shunt resistor based current sensor comprising a busbar with a through hole that functions as a battery post and with a shunt resistor portion. The current sensor further comprises a circuit board which is disposed on the busbar, a pair of connection terminal portions which are disposed corresponding to both end portions of the shunt resistor portion and which are electrically connected to the circuit board. A temperature detecting unit is placed positionally corresponding to a central portion of the shunt resistor portion in the busbar. Further there is disclosed a heat conduction member which is interposed between the busbar and the circuit board.

### SUMMARY

Embodiments of the present invention seek to solve at least one of the problems existing in the prior art to at least some extent.

According to a first broad aspect of present invention, there is provided a signal collection unit of a battery module, the signal collection unit includes: a circuit board having a circuit thereon; a signal collection terminal including a protection cover electrically connected with the circuit and an electric connection sheet connected with the protection cover, the protection cover being disposed on a surface of the circuit board and a chamber being defined by the protection cover and the circuit board, the electric connection sheet being extended beyond an edge of the circuit board; a temperature-sensing element disposed in the chamber and on the surface of the circuit board, and insulated from the protection cover; and a heat conductive-electric isolative material filled within the chamber through an inlet formed in the protection cover.

With the signal collection unit of the present invention, a heat conduction terminal and a current conduction terminal are integrated together, namely the signal collection terminal has both functions of conducting current and conducting heat at the same time. Therefore, a structure of the signal collection unit is simplified, it is easier to layout the signal collection unit, and a stability of the signal collection structure also is improved.

In some embodiments, the signal collection terminal further includes a buffering portion, and the protection cover is connected with the electric connection sheet via the buffering portion.

In some embodiments, the protection cover, the buffering portion and the electric connection sheet are integrally formed.

In some embodiments, the buffering portion has an arc shape.

According to the invention, an inlet is formed in the protection cover such that the heat conductive-electric isolative material is fillable into the chamber via the inlet.

In some embodiments, the temperature-sensing element includes a chip fixed resistor.

In some embodiments, the circuit board includes a print circuit board.

In some embodiments, the circuit board includes a bonding pad, and a bottom of the protection cover is welded with the bonding pad.

According to a second broad aspect of present invention, there is provided a battery module, which includes a battery pack having a plurality of batteries, and a signal collection unit according to above embodiments of the present disclosure. Adjacent batteries are electrically connected with each other via an electric connector, and the signal collection terminal of the signal collection unit is electrically connected with the electric connector.

In some embodiments, the electric connector is welded with an electrode terminal of the battery.

In some embodiments, the plurality of batteries are connected in series, parallel or a combination thereof.

In some embodiments, the battery module further includes a power leading-out sheet electrically connected with the signal collection terminal.

In some embodiments, the battery module further includes snapping members symmetrically disposed in an up and down direction and configured to fasten the circuit board.

In some embodiments, the battery module further includes a side plate and a central plate which are configured to package the battery pack.

In some embodiments, the battery module further includes a connector configured to be connected with other components outside the battery module.

Additional aspects and advantages of embodiments of present invention will be given in part in the following descriptions, become apparent in part from the following descriptions, or be learned from the practice of the embodiments of the present disclosure.

### BRIEF DESCRIPTION OF THE DRAWINGS

The disclosure is illustrated in the accompanying drawings, in which:
Fig. 1 is a schematic view of a signal collection unit of a battery module according to an embodiment of the present disclosure;
Fig. 2 is a partially enlarged view of a signal collection unit of a battery module according to an embodiment of the present disclosure;
Fig. 3 is a schematic view of a signal collection terminal of a signal collection unit according to an embodiment of the present disclosure; and
Fig. 4 is a schematic view of a battery module according to an embodiment of the present disclosure.

### DETAILED DESCRIPTION

Reference will be made in detail to embodiments of the present invention. The same or similar elements and the elements having same or similar functions are denoted by like reference numerals throughout the descriptions. The embodiments described herein with reference to drawings are explanatory, illustrative, and used to generally understand the present disclosure. The embodiments shall not be construed to limit the present disclosure.

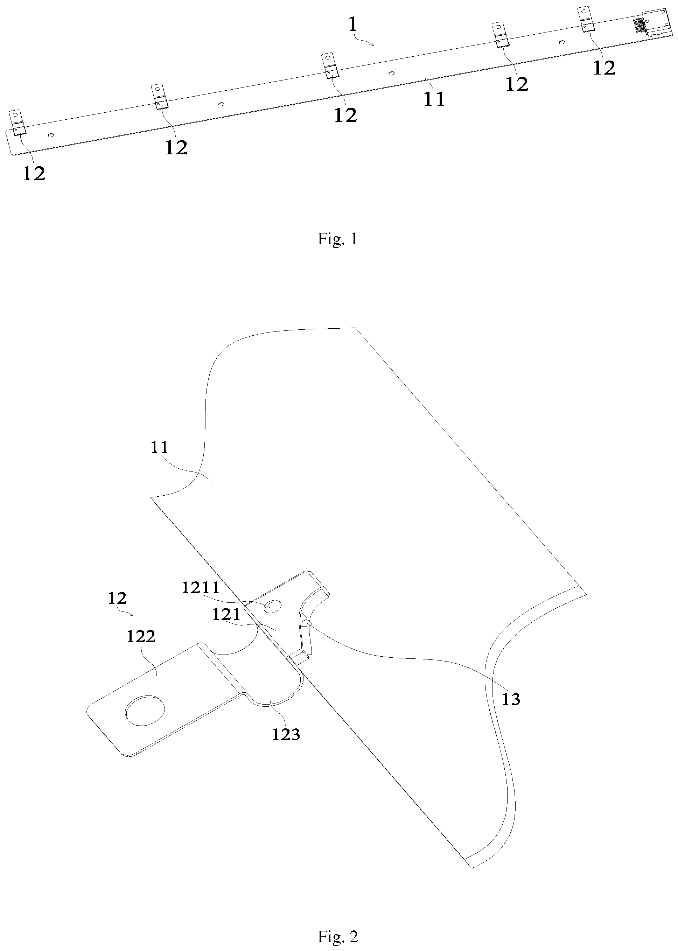

As shown in Figs. 1-4, a signal collection unit 1 of a battery module is provided according to an embodiment of the present disclosure, the signal collection unit 1 includes: a circuit board 11 having a circuit thereon, a signal collection terminal 12 and a temperature-sensing element 13. The signal collection terminal 12 includes a protection cover 121 electrically connected with the circuit and an electric connection sheet 122 connected to the protection cover 121. The protection cover 121 is disposed on a surface of the circuit board 11, and a chamber is defined by the protection cover 121 and the circuit board 11. The electric connection sheet 122 is extended beyond an edge of the circuit board 11, and the temperature-sensing element 13 is disposed in the chamber and on the surface of the circuit board 11 and insulated from the protection cover 121. The signal collection unit 1 further includes a heat conductive-electric isolative material filled in the chamber.

In one embodiment, the signal collection terminal 12 further includes a buffering portion 123, and the protection cover 121 is connected with the electric connection sheet 122 via the buffering portion 123.

In one embodiment, as shown in Fig. 2, the protection cover 121, the buffering portion 123 and the electric connection sheet 122 are integrally formed.

In one embodiment, the buffering portion 123 has an arc shape.

According to the invention, an inlet 1211 is formed in the protection cover 121, and the heat conductive-electric isolative material is filled into the chamber via the inlet 1211. Specifically, the heat conductive-electric isolative material is filled into the chamber defined by the protection cover 121 and the circuit board 11 through the inlet 1211, and thus the temperature-sensing element 13 in the chamber defined by the protection cover 121 and the electric connection sheet 122 is insulated from the protection cover 121. Therefore, a heat conducting terminal and a current conducting terminal are integrated together, that is, the signal collection terminal has both functions of conducting current and conducting heat at the same time.

In one embodiment, the temperature-sensing element 13 includes a chip fixed resistor.

In embodiments of the present disclosure, according to actual needs, the circuit board 11 may further include other sensing elements, such as s current-sensing element, s pressure-sensing element, s concentration-sensing element and a humidness-sensing element. It should be noted that these sensing elements may be connected to the circuit board 11 via the surface mounting technology or other technologies, for example, welding via a bonding pad, and then a gas pressure signal of battery, an electrolyte concentration signal, a humidness signal may be collected. Also, it should be noted that the current-sensing element may be configured as a protection structure which includes a fuse or a protection circuit for over-current protection of the battery, and thus safety of the whole signal collection system can be improved.

In one embodiment, the circuit board 11 includes a print circuit board. Specifically, a circuit layer, the signal collection terminal 12 and the temperature-sensing element 13 are integrated on the print circuit board, and then a signal collection circuit and relevant elements may be well supported. Thus, the structure of the signal collection unit may be simplified, it is easy to arrange the signal collection unit, and the safety and stability of the signal collection structure may be improved.

In one embodiment, the signal collection terminal 12 may be made of metal, for example, aluminum, nickel, copper and their alloys. The signal collection terminal 12 is configured to collect signal parameters, such as an electric signal and a temperature signal of the battery. The number and arrangement mode of the signal collection terminals 12 may be determined according to an arrangement mode of the batteries in the battery module and the actual needs.

In one embodiment, the signal collection terminal 12 is connected with the electric connector 22 via welding and/or a mechanical connection, and then a stable continuity between the signal collection terminal 12 and a conducting circuit may be assured, and effect of signal transmission (for example, the electric signal and a heat signal) may be guaranteed.

In one embodiment, the circuit board 11 includes a bonding pad, and a bottom of the protection cover 121 is welded with the bonding pad. Specifically, a welding pin is disposed on the bottom of the protection cover 121, and the bottom of the protection cover 121 is welded with the bonding pad by the welding pin.

With the signal collection unit according to embodiments of the present disclosure, the heat conducting terminal and current conducting terminal are integrated together, and thus the signal collection terminal has both the functions of conducting current and conducting heat at the same time. Also, the signal collection unit is simplified, it is easy to arrange the signal collection unit, and the safety and stability of the signal collection unit are improved.

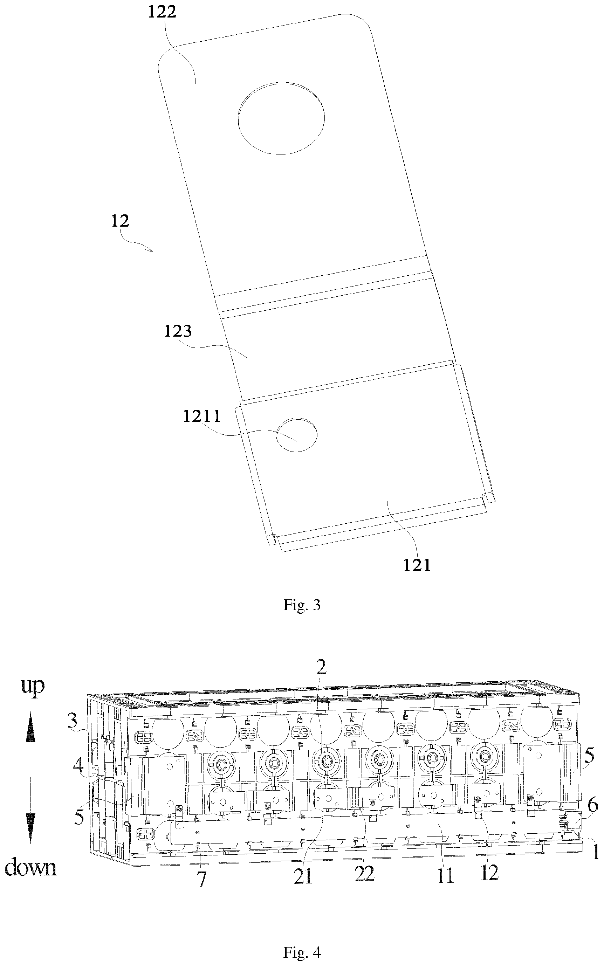

As shown in Fig. 4, embodiments of the present disclosure also provide a battery module, which includes a battery pack 2 including a plurality of batteries 21, and a signal collection unit 1 according to above embodiments of the present disclosure. Adjacent batteries 21 are electrically connected with each other via an electric connector 22, and the signal collection terminal 12 of the signal collection unit 1 is electrically connected with the electric connector 22.

In one embodiment, the electric connector 22 is welded with an electrode terminal of the battery 21.

In one embodiment, the plurality of batteries 21 are connected in series, parallel or a combination thereof.

In one embodiment, the battery module further includes a power leading-out sheet 5 electrically connected to the signal collection terminal 12.

In one embodiment, the battery module further includes snapping members 7 symmetrically disposed in an up and down direction and configured to fasten the circuit board 11.

In one embodiment, the battery module further includes a side plate 3 and a central plate 4, and the side plate 3 and the central plate 4 are configured to package the battery pack 2.

In one embodiment, the battery module further includes a connector 6 configured to be connected to other components outside the battery module. The connector 6 may be fixed on one end of the circuit board 11, and configured to gather a state signal of the battery module and output the state signal to a corresponding device.

Reference throughout this specification to "an embodiment," "some embodiments," "one embodiment", "another example," "an example," "a specific example," or "some examples," means that a particular feature, structure, material, or characteristic described in connection with the embodiment or example is included in at least one embodiment or example of the present disclosure. Thus, the appearances of the phrases such as "in some embodiments," "in one embodiment", "in an embodiment", "in another example," "in an example," "in a specific example," or "in some examples," in various places throughout this specification are not necessarily referring to the same embodiment or example of the present disclosure. Furthermore, the particular features, structures, materials, or characteristics may be combined in any suitable manner in one or more embodiments or examples.

## Claims

1. A signal collection unit (1) of a battery module, comprising:
a circuit board (11) having a circuit thereon;
a signal collection terminal (12) comprising a protection cover (121) electrically connected with the circuit and an electric connection sheet (122) connected with the protection cover (121), the protection cover being disposed on a surface of the circuit board (11) and a chamber being defined by the protection cover (121) and the circuit board (11), the electric connection sheet (122) being extended beyond an edge of the circuit board (11);
a temperature-sensing element (13) disposed in the chamber and on the surface of the circuit board (11), and insulated from the protection cover (121); and
a heat conductive-electric isolative material filled within the chamber through an inlet (1211) being formed in the protection cover (121).

2. The signal collection unit (1) of claim 1, wherein the signal collection terminal (12) further comprises a buffering portion (123), and the protection cover (121) is connected with the electric connection sheet (122) via the buffering portion (123).

3. The signal collection unit (1) of claim 2, wherein the protection cover (121), the buffering portion (123) and the electric connection sheet (122) are integrally formed.

4. The signal collection unit (1) of claim 2 or 3, wherein the buffering portion (123) has an arc shape.

5. The signal collection unit (1) of any one of claims 1-4, wherein the temperature-sensing element (13) comprises a chip fixed resistor.

6. The signal collection unit (1) of any one of claims 1-5, wherein the circuit board (11) comprises a print circuit board.

7. The signal collection unit (1) of any one of claims 1-6, wherein the circuit board (11) comprises a bonding pad, and a bottom of the protection cover (121) is welded with the bonding pad.

8. A battery module, comprising:
a battery pack (2) comprising a plurality of batteries (21), adjacent batteries (21) being electrically connected with each other by an electric connector (22); and
a signal collection unit (1) according to any one of claims 1-7,
wherein the signal collection terminal (12) of the signal collection unit (1) is electrically connected with the electric connector (22).

9. The battery module of claim 8, wherein the electric connector (22) is welded with an electrode terminal of the battery (21).

10. The battery module of claim 8 or 9, wherein the plurality of batteries (21) are connected in series, parallel or a combination thereof.

11. The battery module of any one of claims 8-10, further comprising a power leading-out sheet (5) electrically connected with the signal collection terminal (12).

12. The battery module of any one of claims 8-11, further comprising snapping members (7) symmetrically disposed in an up and down direction and configured to fasten the circuit board (11).

13. The battery module of any one of claims 8-12, further comprising a side plate (3) and a central plate (4) which are configured to package the battery pack (2).

14. The battery module of any one of claims 8-13, further comprising a connector (6) configured to be connected with other components outside the battery module.

## Patentansprüche

1. Signalsammeleinheit (1) eines Batteriemoduls, folgendes aufweisend:
eine Leiterplatte (11) mit einer Schaltung darauf;
einen Signalsammelanschluss (12) mit einer Schutzabdeckung (121), die elektrisch mit der Schaltung verbunden ist, und einem elektrischen Verbindungsblech (122), das mit der Schutzabdeckung (121) verbunden ist, wobei die Schutzabdeckung auf einer Oberfläche der Leiterplatte (11) angeordnet ist und eine Kammer durch die Schutzabdeckung (121) und die Leiterplatte (11) definiert ist, wobei das elektrische Verbindungsblech (122) über einen Rand der Leiterplatte (11) hinausragt;
ein Temperaturfühler- bzw. -messelement (13), das in der Kammer und auf der Oberfläche der Leiterplatte (11) angeordnet und von der Schutzabdeckung (121) isoliert ist; und
ein wärmeleitendes, elektrisch isolierendes Material, das durch einen in der Schutzabdeckung (121) ausgebildeten Einlass (1211) in die Kammer eingefüllt ist.

2. Signalsammeleinheit (1) nach Anspruch 1, wobei der Signalsammelanschluss (12) ferner einen Pufferabschnitt (123) aufweist und die Schutzabdeckung (121) über den Pufferabschnitt (123) mit dem elektrischen Verbindungsblech (122) verbunden ist.

3. Signalsammeleinheit (1) nach Anspruch 2, wobei die Schutzabdeckung (121), der Pufferabschnitt (123) und das elektrische Verbindungsblech (122) einstückig ausgebildet sind.

4. Signalsammeleinheit (1) nach Anspruch 2 oder 3, wobei der Pufferabschnitt (123) eine Bogenform aufweist.

5. Signalsammeleinheit (1) nach einem der Ansprüche 1 bis 4, wobei das Temperaturfühler- bzw. -messelement (13) einen Chip-Festwiderstand umfasst.

6. Signalsammeleinheit (1) nach einem der Ansprüche 1 bis 5, wobei die Leiterplatte (11) eine gedruckte Leiterplatte umfasst.

7. Signalsammeleinheit (1) nach einem der Ansprüche 1 bis 6, wobei die Leiterplatte (11) ein Bonding Pad bzw. Lötfeld aufweist und eine Unterseite der Schutzabdeckung (121) mit dem Bonding Pad verschweißt ist.

8. Batteriemodul, umfassend:
ein Batteriepaket (2), das eine Vielzahl von Batterien (21) umfasst, wobei benachbarte Batterien (21) durch einen elektrischen Verbinder (22) elektrisch miteinander verbunden sind; und
eine Signalsammeleinheit (1) nach einem der Ansprüche 1 bis 7,
wobei der Signalsammelanschluss (12) der Signalsammeleinheit (1) elektrisch mit dem elektrischen Verbinder (22) verbunden ist.

9. Batteriemodul nach Anspruch 8, wobei der elektrische Verbinder (22) mit einem Elektrodenanschluss der Batterie (21) verschweißt ist.

10. Batteriemodul nach Anspruch 8 oder 9, wobei die Vielzahl von Batterien (21) in Reihe, parallel oder in einer Kombination davon verschaltet sind.

11. Batteriemodul nach einem der Ansprüche 8 bis 10, das ferner ein Stromabführungsblech (5) umfasst, das elektrisch mit dem Signalsammelanschluss (12) verbunden ist.

12. Batteriemodul nach einem der Ansprüche 8 bis 11, das ferner Schnappelemente (7) umfasst, die symmetrisch in einer Auf- und Abwärtsrichtung angeordnet sind und dazu eingerichtet sind, die Leiterplatte (11) zu befestigen.

13. Batteriemodul nach einem der Ansprüche 8 bis 12, ferner umfassend eine Seitenplatte (3) und eine Mittelplatte (4), die dazu eingerichtet sind, das Batteriepaket (2) zu verpacken.

14. Batteriemodul nach einem der Ansprüche 8 bis 13, das ferner einen Verbinder (6) aufweist, der dazu eingerichtet ist, mit anderen Komponenten außerhalb des Batteriemoduls verbunden zu werden.

## Revendications

1. Unité de collecte de signaux (1) d'un module de batterie, comprenant :
une carte de circuit (11) portant un circuit ;
un terminal de collecte de signaux (12) comprenant un couvercle de protection (121) connecté électriquement au circuit et une feuille de connexion électrique (122) connectée au couvercle de protection (121), le couvercle de protection étant disposé sur une surface de la carte de circuit (11) et une chambre étant définie par le couvercle de protection (121) et la carte de circuit (11), la feuille de connexion électrique (122) dépassant d'un bord de la carte de circuit (11) ;
un élément sensible à la température (13) disposé dans la chambre et sur la surface de la carte de circuit (11), et isolé du couvercle de protection (121) ; et
un matériau conducteur de chaleur-isolant électrique rempli dans la chambre par une entrée (1211) formée dans le couvercle de protection (121).

2. Unité de collecte de signaux (1) selon la revendication 1, dans laquelle le terminal de collecte de signaux (12) comprend en outre une partie amortissante (123), et le couvercle de protection (121) est connecté à la feuille de connexion électrique (122) par l'intermédiaire de la partie amortissante (123).

3. Unité de collecte de signaux (1) selon la revendication 2, dans laquelle le couvercle de protection (121), la partie amortissante (123) et la feuille de connexion électrique (122) sont formés d'un seul tenant.

4. Unité de collecte de signaux (1) selon la revendication 2 ou 3, dans laquelle la partie amortissante (123) a une forme d'arc.

5. Unité de collecte de signaux (1) selon l'une quelconque des revendications 1 à 4, dans laquelle l'élément sensible à la température (13) comprend un résisteur fixe à puce.

6. Unité de collecte de signaux (1) selon l'une quelconque des revendications 1 à 5, dans laquelle la carte de circuit (11) comprend une carte de circuit imprimé.

7. Unité de collecte de signaux (1) selon l'une quelconque des revendications 1 à 6, dans laquelle la carte de circuit (11) comprend une plage de connexion, et un fond du couvercle de protection (121) est soudé avec la plage de connexion.

8. Module de batterie, comprenant :
un bloc de batteries (2) comprenant une pluralité de batteries (21), les batteries adjacentes (21) étant connectées électriquement les unes aux autres par un connecteur électrique (22) ; et
une unité de collecte de signaux (1) selon l'une quelconque des revendications 1 à 7,
dans lequel le terminal de collecte de signaux (12) de l'unité de collecte de signaux (1) est connecté électriquement au connecteur électrique (22).

9. Module de batterie selon la revendication 8, dans lequel le connecteur électrique (22) est soudé avec un terminal d'électrode de la batterie (21).

10. Module de batterie selon la revendication 8 ou 9, dans lequel la pluralité de batteries (21) sont connectées en série, en parallèle ou une combinaison de celles-ci.

11. Module de batterie selon l'une quelconque des revendications 8 à 10, comprenant en outre une feuille de sortie de courant (5) connectée électriquement au terminal de collecte de signal (12).

12. Module de batterie selon l'une quelconque des revendications 8 à 11, comprenant en outre des éléments d'encliquetage (7) disposés symétriquement dans une direction ascendante et descendante et configurés pour fixer la carte de circuit (11).

13. Module de batterie selon l'une quelconque des revendications 8 à 12, comprenant en outre une plaque périphérique (3) et une plaque centrale (4) qui sont configurées pour emballer le bloc de batterie (2).

14. Module de batterie selon l'une quelconque des revendications 8 à 13, comprenant en outre un connecteur (6) configuré pour être connecté à d'autres composants à l'extérieur du module de batterie.
